# EUROPEAN PATENT APPLICATION

(11) **EP 4 703 958 A1**
(43) Date of publication of application: **04.03.2026**
(21) Application number: 24465559.3
(22) Date of filing: 27.08.2024
(51) Int. Cl.: G06F 30/33, G06F 40/20

(54) **METHOD TO CHECK A MACHINE LANGUAGE DESCRIPTION OF A VERIFICATION ENVIRONMENT, VERIFICATION DEVICE, COMPUTER PROGRAM PRODUCT AND COMPUTER-READABLE STORAGE MEDIUM**

(71) Applicant: Siemens Aktiengesellschaft, 80333 München (DE)
(72) Inventor: BORZASI, David, 500046 Brasov (RO); BANCIU, Nicolae-Alexandru, 500096 Brasov (RO); GHEORGHE, Stefan, 100456 Ploiesti, Prahova (RO); GONTIA, Flavia, 500003 Brasov (RO)
(74) Representative: Fierascu, Cosmina-Catrinel

(57) **Abstract**

The invention relates to a method to check a machine language description of a verification environment, the method comprising the following steps performed by a verification device (10):
- Receiving from a control device an initial set of natural language descriptions comprising initial requirements, initial features and initial verification items related to the verification environment;
- Receiving from the control device the machine language description of the verification environment; Analyzing the machine language description of the verification environment in a predefined extraction procedure to generate an extracted set of natural language descriptions comprising extracted requirements, extracted features and extracted verification items based on the machine language description of the verification environment; Comparing the extracted set of natural language descriptions with the initial set of natural language descriptions to evaluate a degree of similarity between the sets, using a language interpretation module of the verification device (10) in a comparison procedure.

## Description

The present invention relates to a method to check a machine language description of a verification environment, a verification device, a computer program product and a computer-readable storage medium.

The state-of-the-art flow of digital hardware design is based on the presumption that all through the flow, the artefacts described in natural language (requirements, features, verification items) are all interpreted correctly by the engineers involved in the design and verification process. All these artefacts extracted from the natural language descriptions are implemented as machine language descriptions. Metrics are defined and implemented in machine language to measure during the verification process how much of the machine language version of the verification items have been checked against the machine language version of the features.

The quantitative measurement of this metric does not quantify the "interpretation correctness" of the artefacts described in natural language. Incorrect or incomplete interpretation of the natural language artefacts can induce errors (with different levels of severity) in either the implemented design or in the verification environment. These errors can affect the verification process: the process remains incomplete (undetected errors in design) or incorrect (a different design functionality is implemented and verified, this case being even worse than in the incomplete verification case).

The four-eye principle is state-of-the-art in design and verification process of digital integrated circuits. This principle states that always at least two actors analyze the artefacts and define the verification constructs to be implemented (as well as the expected verification results). Applying this principle still does not ensure that the verification process did not miss some of the intentions (requirements, features, and verification items). This can be caused by incomplete or incorrect interpretation by the actors or by faulty implementation of the verification environment, features, requirements.

It is an object of the present invention to provide a solution for ensuring that a machine language description of a verification environment complies with intentions of the verification procedure.

This objective is achieved by the respective subject matter of the independent claims. Further implementations and preferred embodiments are subject matter of the dependent claims.

A first aspect of the present invention relates to a method to check a machine language description of a verification environment. The method is performed by a verification device.

The method begins by receiving an initial set of natural language descriptions comprising initial requirements, initial features, and initial verification items. These elements are provided by a control device and served as a foundation for creating the machine language description of the verification environment during a generation procedure. The elements are provided in natural language. Natural language means, that they are provided in human readable language.

The method further comprises receiving the machine language description of the verification environment, such as a VHDL or Verilog code, which is used to describe a behavior of a hardware being verified. The machine language description of the verification environment should comply to the initial set of natural language descriptions.

An interpretation module within the verification device extracts an extracted set of natural language descriptions from this machine language description, comprising extracted requirements, extracted features, and extracted verification items. In other words, the interpretation module is a module configured to read the machine language description and to extract the extracted requirements, extracted features, and extracted verification items from the machine language description. These elements describe the requirements, features and items according to the machine language description.

Next, the extracted set of natural language descriptions is compared with the initial set of natural language descriptions to evaluate a degree of similarity between the respective sets using a language interpretation module. This comparison may involve analyzing the syntax, semantics, and context of the natural language descriptions to check, whether they match. Finally, based on these similarities between the sets, the verification device determines a degree of similarity between the sets. This degree of similarity may help verify whether the machine language description accurately reflects the initial set of the natural language descriptions.

The verification device sends a result signal, comprising the degree of similarity between the sets to the control device. The invention has the advantage that the method allows to identify, whether the machine language description complies with the initial set of natural language descriptions. Therefore, the invention may prevent wrong interpretations of verification procedures caused by a misinterpretation of natural language descriptions.

According to a further embodiment of the present invention, the method relates to the following steps performed by the verification device. The method comprises performing a verification procedure according to the machine language description of the verification environment. In other words, the verification device provides the verification environment and performs the verification procedure in the verification environment according to the machine language description of the verification environment. In a next step, the verification device sends a verification signal to the control device. The verification signal comprises verification data of the verification procedure, comprising a verification result according to a predefined verification metric.

According to a further embodiment of the present invention, the performing of the verification procedure requires that the degree of similarity is above a predefined threshold degree. In other words, the predefined threshold degree is set in the verification device. The degree of similarity must be above the predefined threshold degree to perform the verification procedure by the verification device. The embodiment has the advantage, that the verification procedure is denied by the verification device, when the degree of similarity indicates, that the machine language description does not comply with the initial set of natural language descriptions.

According to a further embodiment of the present invention, the verification result depends on the degree of similarity. In other words, the verification device performs the verification procedure and determines the verification result. The verification result depends on state-of-the-art results of the verification procedure. The verification result also depends on the degree of similarity. Therefore, the verification result may be negative, if the degree of similarity is too low.

According to a further embodiment of the present invention, the comparison procedure comprises a determination of degrees of similarity between the respective elements of the sets. In other words, the verification device determines the similarities between the respective elements of the sets and evaluates respective degrees of similarities. Therefore, a finer analysis of dissimilarities between the sets is possible compared to a provision of a single degree of similarity related to the whole sets.

According to a further embodiment of the present invention, the degree of similarity depends on a correctness of the extracted set compared to the initial set. In other words, if the extracted set is largely consistent with the initial set, then the degrees of similarity will be high, indicating that the machine language representation accurately reflects the intended design requirements and features. However, if there are significant discrepancies between the two sets, then the degrees of similarity will be low, indicating potential errors or inconsistencies in the verification environment. By assessing the correctness of the extracted set compared to the initial set and calculating the degrees of similarity between the respective elements of the sets, this method can help ensure that the machine language representation accurately reflects the intended design requirements and features for digital hardware designs. This, in turn, can improve the accuracy and reliability of the verification process, reducing the risk of errors and improving the overall quality of the design.

According to a further embodiment of the present invention, the degree of similarity depends on a coverage of the initial set by the extracted set. The coverage of the initial set by the extracted set refers to the extent to which the elements in the initial set are included in the extracted set. If the extracted set has a high coverage of the initial set, then the degree of similarity between the respective elements will be higher, indicating that the machine language representation accurately reflects the intended design requirements and features. However, if the coverage is low, meaning that many elements in the initial set are not included in the extracted set, then the degree of similarity between the respective elements will be lower, suggesting potential errors or inconsistencies in the verification environment. By assessing the coverage of the initial set by the extracted set and calculating the degree of similarity between the respective elements of the sets, this method can help ensure that the machine language representation accurately reflects the intended design requirements and features for digital hardware designs. This, in turn, can improve the accuracy and reliability of the verification process, reducing the risk of errors and improving the overall quality of the design.

A second aspect of the present invention relates to a verification device. The verification device is configured to receive from a control device an initial set of natural language descriptions comprising initial requirements, initial features and initial verification items related to the verification environment. The verification device is configured to receive from the control device the machine language description of the verification environment. The verification device is configured to analyze the machine language description of the verification environment in a predefined extraction procedure to generate an extracted set of natural language descriptions comprising extracted requirements, extracted features and extracted verification items based on the machine language description of the verification environment, using an interpretation module of the verification device. The verification device is configured to compare the extracted set of natural language descriptions with the initial set of natural language descriptions to evaluate a degree of similarity between the sets, using a language interpretation module of the verification device in a comparison procedure. The verification device is configured to send a result signal, comprising the degree of similarity between the sets to the control device.

A third aspect of the invention is related to a computer program product comprising program code for performing a method according to the first aspect of the present. The computer program product may also be regarded as a computer program.

A fourth aspect of the invention is related to a computer-readable storage medium comprising at least the computer program product according to the third aspect.

The verification device may comprise computing devices to perform steps of the methods.

A computing device may in particular be understood as a data processing device, which comprises processing circuitry. The computing device may therefore in particular process data to perform computing operations. This may also include operations to perform indexed accesses to a data structure, for example a look-up table, LUT.

In particular, the computing device may include one or more computers, one or more microcontrollers, and/or one or more integrated circuits, for example, one or more application-specific integrated circuits, ASIC, one or more field-programmable gate arrays, FPGA, and/or one or more systems on a chip, SoC. The computing device may also include one or more processors, for example one or more microprocessors, one or more central processing devices, CPU, one or more graphics processing devices, GPU, and/or one or more signal processors, in particular one or more digital signal processors, DSP. The computing device may also include a physical or a virtual cluster of computers or other of said devices.

In various embodiments, the computing device includes one or more hardware and/or software interfaces and/or one or more memory devices.

A memory device may be implemented as a volatile data memory, for example a dynamic random access memory, DRAM, or a static random access memory, SRAM, or as a non-volatile data memory, for example a read-only memory, ROM, a programmable read-only memory, PROM, an erasable read-only memory, EPROM, an electrically erasable read-only memory, EEPROM, a flash memory or flash EEPROM, a ferroelectric random access memory, FRAM, a magnetoresistive random access memory, MRAM, or a phase-change random access memory, PCRAM.

Independent of the grammatical term usage, individuals with male, female or other gender identities are included within the term.

Further features of the invention are apparent from the claims, the figures and the figure description. The features and combinations of features mentioned above in the description as well as the features and combinations of features mentioned below in the description of figures and/or shown in the figures may be comprised by the invention not only in the respective combination stated, but also in other combinations. In particular, embodiments and combinations of features, which do not have all the features of an originally formulated claim, are also comprised by the invention. Moreover, embodiments and combinations of features which go beyond or deviate from the combinations of features set forth in the recitations of the claims are comprised by the invention.

In the following, the invention will be explained in detail with reference to specific exemplary implementations and respective schematic drawings. In the drawings, identical or functionally identical elements may be denoted by the same reference signs. The description of identical or functionally identical elements is not necessarily repeated with respect to different figures.

In the figures,
FIG 1 shows a schematic illustration of a verification procedure according to the state of the art; and
FIG 2 shows a schematic illustration of the method.

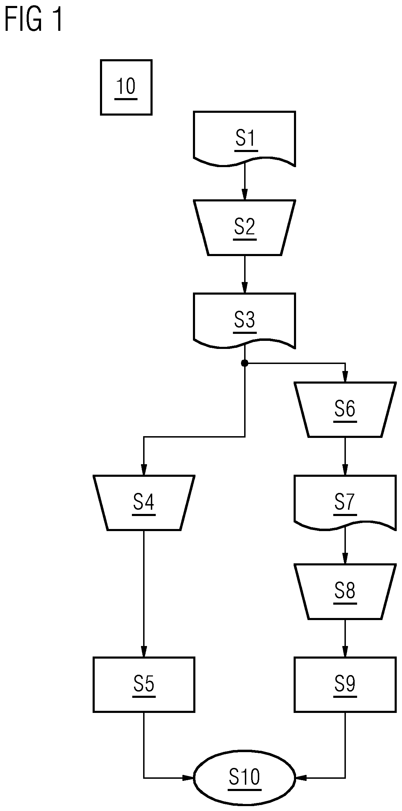

FIG 1 shows a schematic illustration of a verification procedure according to the state of the art.

FIG 1 presents the state-of-the-art digital integrated circuit design and verification flow. Digital IC design starts with a set of requirements described in natural language that address the question of what the design is intended to do (S1). The implementation details, i.e., the features of the design are a set of technical solutions that answer the question of how the requirements are implemented - also described in natural language (S3). The features are defined by interpreting the requirements (S2). This interpretation is a manual step that is performed by expert engineers.

On the one hand, the design features are implemented in digital hardware description languages (e.g., VHDL, Verilog). This implementation is a description of the design features in machine language and is an input to several other computer automated steps in the design process that finally result in the physical product (S5). Again, translating the features from natural to machine language involves interpretation - a manual step that is performed by expert engineers (S4).

On the other hand, based on the design features, a set of verification items are formulated in natural language (S7). These items answer the question if the design features are implemented correctly in the hardware description language. The verification items are implemented in digital hardware verification languages (e.g., e, SystemVerilog, SVA, PSL). This implementation is a description of the verification items in machine language and is the input to the verification of the digital design's implementation (S9). Again, all "translations" of the features (natural language) to verification items (natural language) to the verification environment (machine language) involves the "interpretation" of the various artefacts all described in natural language - manual steps that are performed by expert engineers (S6 and S8).

The verification of the digital design is a machine-based analysis that provides metrics of how much of the verification items have been verified on the digital design, i.e., the digital hardware language implementation of the digital design (S10).

The state-of-the-art flow requires at least two actors (e.g., engineers) that interpret the design's features: the actor implementing the digital hardware description of the design (S5) and the actor implementing the verification environment (S9). This ensures the two-eye principle that is fundamental to digital hardware development.

Finally, the verification metrics are used to deduce the implementation score of the initial set of requirements (an extension to S10).

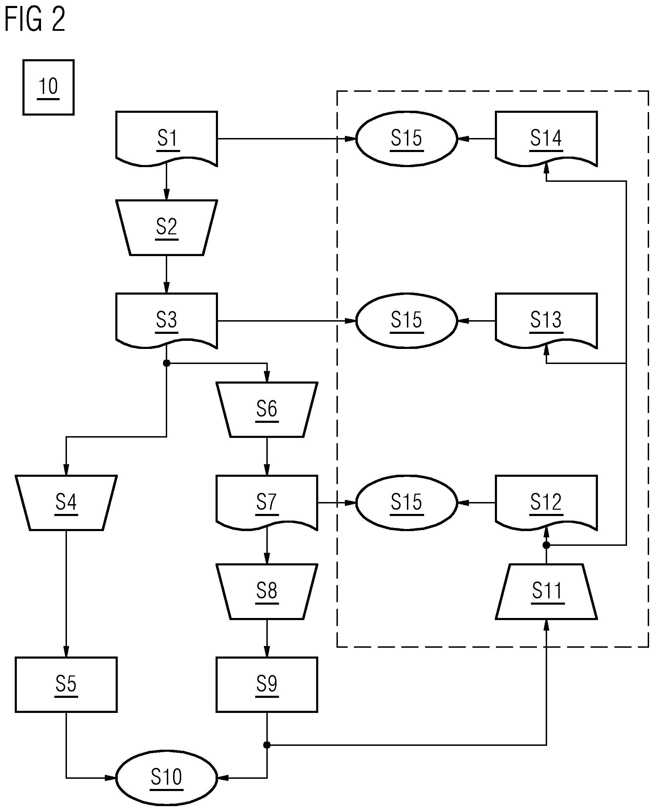

FIG 2 shows a schematic illustration of the method.

FIG 2 presents the proposed solution to the problem of correct interpretation. The method proposes to solve the problem of "correct interpretation" by quantifying the interpretation and translation of the requirements, features, and verification items provided as natural language descriptions into the verification environment provided as machine language description. The verification device may extract (S11) from the machine language description of the verification environment another set (or subsets) of requirements (S14), features (S13) and verification items (S12). This second set (or subsets) of extracted artefacts may be compared against the initial set of artefacts that had been used during the design and verification flow. The two sets of artefacts, or only a subset of them, original and extracted, may be compared by the verification device (S15). The comparison process may be composed first of quantifying the information in the artefacts, and second measuring the similarities of quantified elements. A degree of similarity between the two sets of artefacts may indicates the correctness of the initial interpretation of the requirements. The comparison process (S15) may be but is not limited to fully and partially automated machine implementations.

The novelty of the proposed solution is that the verification environment (i.e., machine language representation of the requirements, features, and verification items) is machine interpreted and converted back to a natural language representation of the verification items, features, and requirements. The similarity between the original artefacts and the extracted artefacts is considered in addition to the verification metrics to determine the completion of the digital design verification process. The state-of-the-art flow comprises of human interpretation of the natural language artefacts and concludes with a visual check of the verification results. With the proposed solution an automatic machine-based interpretation of the verification environment is introduced that contributes to the validation of the initial requirements.

### List of Reference

- 10: verification device
- S1-S15: steps

## Claims

1. A method to check a machine language description of a verification environment, the method comprising the following steps performed by a verification device (10):
- Receiving from a control device an initial set of natural language descriptions comprising initial requirements, initial features and initial verification items related to the verification environment;
- Receiving from the control device the machine language description of the verification environment;
- Analyzing the machine language description of the verification environment in a predefined extraction procedure to generate an extracted set of natural language descriptions comprising extracted requirements, extracted features and extracted verification items based on the machine language description of the verification environment, using an interpretation module of the verification device (10),
- Comparing the extracted set of natural language descriptions with the initial set of natural language descriptions to evaluate a degree of similarity between the sets, using a language interpretation module of the verification device (10) in a comparison procedure; and
- Sending a result signal, comprising the degree of similarity between the sets to the control device.

2. The method according to claim 1, the method comprising the following steps performed by the verification device (10):
- Performing a verification procedure according to the machine language description of the verification environment; and
- Sending a verification signal to the control device, the verification signal comprising verification data of the verification procedure, comprising a verification result according to a predefined verification metric.

3. The method according to claim 2, wherein the performing of the verification procedure requires that the degree of similarity is above a predefined threshold degree.

4. The method according to claim 2 or 3, wherein the verification result depends on the degree of similarity.

5. The method according to any one of the preceding claims, wherein the comparison procedure comprises a determination of degrees of similarity between the respective elements of the sets.

6. The method according to any one of the preceding claims, wherein the degrees depend on a correctness of the extracted set compared to the initial set.

7. The method according to any one of the preceding claims, wherein the degree of similarity depends on a coverage of the initial set by the extracted set.

8. Verification device (10) configured to
- Receive from a control device an initial set of natural language descriptions comprising initial requirements, initial features and initial verification items related to the verification environment;
- Receive from the control device the machine language description of the verification environment;
- Analyze the machine language description of the verification environment in a predefined extraction procedure to generate an extracted set of natural language descriptions comprising extracted requirements, extracted features and extracted verification items based on the machine language description of the verification environment, using an interpretation module of the verification device (10),
- Compare the extracted set of natural language descriptions with the initial set of natural language descriptions to evaluate a degree of similarity between the sets, using a language interpretation module of the verification device (10) in a comparison procedure; and
- Send a result signal, comprising the degree of similarity between the sets to the control device.

9. A computer program product comprising program code for performing a method according to any one of the preceding claims 1 to 7.

10. A computer-readable storage medium comprising at least the computer program product according to claim 9.
